# EUROPÄISCHE PATENTSCHRIFT

(11) **EP 0 383 025 B1**
(45) Veröffentlichungstag und Bekanntmachung des Hinweises auf die Patenterteilung: **12.10.1994**
(21) Anmeldenummer: 90100748.4
(22) Anmeldetag: 15.01.1990
(51) Int. Cl.: H05K 5/06, H05K 5/00

(54) **Verfahren zum Verkapseln von elektrischen oder elektronischen Bauelementen oder Baugruppen und Verkapselung von elektrischen oder elektronischen Bauelementen oder Baugruppen**
Device for enclosing of electrical or electronical components or component groups and enclosing of electrical or electronical components or component groups
Dispositif pour le blindage de composants ou de groupes de composants électriques ou électroniques et blindage de composants ou de groupes de composants électriques ou électroniques

(30) Priorität: 19.05.1989 EP 89109084; 16.01.1989 DE 3901112
(43) Veröffentlichungstag der Anmeldung: 22.08.1990
(73) Patentinhaber: SIEMENS AKTIENGESELLSCHAFT, 80333 München (DE)
(72) Erfinder: Rauchmaul, Siegfried, D-8000 München 70 (DE); Schmidt, Hans-Fr., Dr., D-8191 Eurasburg (DE); Bednarz, Jürgen, Dr., D-8122 Penzberg (DE); Peltz, Hanns-Heinz, D-8000 München 80 (DE); Horsmann, Karl-Heinz, D-8000 München 90 (DE); Criens, Ralf, Dr., D-8000 München 40 (DE); Scheffler, Horst, D-8000 München 83 (DE)

(56) Entgegenhaltungen:
- EP-A- 0 071 233
- EP-A- 0 157 938
- DE-A- 2 451 895
- DE-A- 3 603 912
- FR-A- 2 299 716

## Beschreibung

Die Erfindung betrifft ein Verfahren zum Verkapseln von elektrischen oder elektronischen Bauelementen oder Baugruppen in einem aus mindestens zwei Gehäuseteilen zusammengefügten Gehäuse, aus welchem Anschlußeine nach außen geführt sind, sowie eine Verkapselung von elektrischen oder elektronischen Bauelementen oder Baugruppen in einem aus mindestens zwei Gehäuseteilen zusammengefügten Gehäuse, aus welchem Anschlußeine nach außen geführt sind.

Es ist bekannt, daß duroplastisch umhüllte elektronische Bauelemente, wie z.B. integrierte Schaltungen, oder Baugruppen, wie z.B. Hybridschaltungen, durch innere Spannungen bzw. durch Korrosion zerstört werden. Die inneren Spannungen werden durch Kunststoff-Schwindung sowie durch unterschiedliche thermische Dehnungen von Bauelement bzw. Baugruppe, Systemträger und Kunststoff erzeugt. Es wird daher eine Umhüllung gefordert, die sowohl die Spannungen und die unterschiedlichen Dehnungen kompensiert als auch Schutz gegen innere Korrosion bietet. Je nach Bauform werden derzeit z.B. integrierte Schaltkreise vor der duroplastischen Umhüllung kostenintensiv mit einer Schutzschicht abgedeckt, die beispielsweise aus Plasmanitrid, Polyimid und/oder Gel-Tropfen besteht. Dabei bleiben die Bereiche außerhalb des Chips wie z.B. der Chip-Umfang und die Kontaktstelle zwischen Bonddraht und dem zugeordneten Anschlußbein ungeschützt. Beim Umhüllen von Baugruppen wird eine elastische Zwischenschicht zum Schutz der Bauelemente und der Schaltung angewandt, die beispielsweise aus Silikongel oder aus einem elastischen Acrylat besteht.

Es sind auch bereits Verfahren zum Verkapseln von elektrischen oder elektronischen Bauelementen oder Baugruppen und Verkapselungen bekannt, bei welchen die Bauelemente oder Baugruppen in einem geschlossenen Gehäuse untergebracht werden, aus welchem nur die Anschlußbeine herausgeführt sind. Diese aus mindestens zwei Gehäuseteilen zusammengefügten Gehäuse bieten einen mechanischen Schutz der Bauelemente oder Baugruppen und insbesondere auch der empfindlichen Verbindungen zu den Anschlußbeinen. Andererseits kann jedoch durch die Fügestellen des Gehäuses und im Durchtrittsbereich der Anschlußbeine Feuchtigkeit in das Gehäuse eindringen, d.h. der Schutz gegen innere Korrosion ist unzureichend.

Aus der EP-A-0 157 938 ist ein Verfahren zum Verkapseln von elektrischen oder elektronichen Bauelementen oder Baugruppen in einem aus zwei aus duroplastischem Kunststoff bestehenden Gehäuseteilen zusammengefügten Gehäuse bekannt, wobei aus dem Gehäuse Anschlußbeine nach außen geführt sind. Bei diesem bekannten Verfahren wird das gesamte Gehäuse in einem Spritzpreßverfahren mit einer Außenkapsel aus duroplastischem Kunststoff umhüllt.

Der Erfindung liegt die Aufgabe zugrunde, ein wirtschaftliches und leicht automatisierbares Verfahren zum Verkapseln von elektrischen oder elektronischen Bauelementen oder Baugruppen zu schaffen, das sowohl eine Kompensation von Spannungen und unterschiedlichen Dehnungen ermöglicht als auch einen sicheren Schutz gegen innere Korrosion bietet. Ferner soll eine den genannten Anforderungen genügende Verkapselung angegeben werden.

Diese Aufgabe wird erfindungsgemäß dadurch gelöst, daß zumindest im Bereich der Fügestellen des Gehäuses und im Austrittsbereich der Anschlußbeine an das Gehäuse eine Außenkapsel aus einem thermoplastischen Kunststoff durch Spritzgießen angeformt wird.

Der Erfindung liegt die Erkenntnis zugrunde, daß die Vorteile einer Unterbringung von Bauelementen oder Baugruppen in Gehäusen dann erst voll genutzt werden können, wenn gleichzeitig eine dichte Verkapselung im Bereich der Fügestellen des Gehäuses und im Austrittsbereich der Anschlußbeine ein Eindringen von Feuchtigkeit verhindert und damit einen sicheren Schutz vor innerer Korrosion bietet. Die Anformung dieser aus thermoplastischem Kunststoff bestehenden Verkapselung durch Spritzgießen gewährleistet, daß die aus dem Gehäuse austretenden Anschlußbeine in dem besonders kritischen Austrittsbereich vollständig umspritzt werden und auch die Fügestellen vollständig abgedichtet werden. Durch die Verwendung eines thermoplastischen Kunststoffes für die Außenkapsel können beim Spritzgießen äußerst geringe Taktzeiten erreicht werden, d.h. das erfindungsgemäße Verfahren ermöglicht ein wirtschaftliches und insbesondere für die Massenfertigung geeignetes Verkapseln von elektrischen oder elektronischen Bauelementen oder Baugruppen.

Gemäß einer bevorzugten Ausgestaltung des erfindungsgemäßen Verfahrens ist vorgesehen, daß die Gehäuse aus einem Gehäuseunterteil und einem Gehäuseoberteil zusammengefügt werden, daß das Gehäuseunterteil durch Spritzgießen hergestellt wird und daß die Anschlußbeine beim Spritzgießen des Gehäuseunterteils im Durchtrittsbereich zumindest teilweise umspritzt werden. Auch hier können dann die Vorteile des Spritzgießens auf die Herstellung des Gehäuseunterteils übertragen werden, wobei auch gleichzeitig der Austrittsbereich der Anschlußbeine aus dem Gehäuse besser abgedichtet wird und sich somit eine weitere Steigerung der gesamten Dichtwirkung ergibt. Außerdem kann dann nach dem Spritzgießen des Gehäuseunterteils das Bauelement oder die Baugruppe am Boden des Gehäuseunterteils verankert werden, so daß dann die inneren Enden der Anschlußbeine mit den zugeordneten Anschlüssen des Bauelements oder der Baugruppe elektrisch leitend verbunden werden können. Eine Beeinträchtigung der empfindlichen elektrisch leitenden Verbindungen beim weiteren Verkapseln kann bei dieser Vorgehensweise dann mit Sicherheit ausgeschlossen werden.

Gemäß einer Variante des erfindungsgemäßen Verfahrens können die Gehäuse auch aus einem Gehäuseunterteil, einem Gehäusemittelteil und einem Gehäuseoberteil zusammengefügt werden, wobei das Gehäusemittelteil durch Spritzgießen hergestellt wird und die Anschlußbeine beim Spritzgießen des Gehäuseunterteils im Durchtrittsbereich vollständig umspritzt werden. Bei dieser Variante können also die Anschlußbeine beim Spritzgießen des Gehäusemittelteils vollständig umspritzt werden, d.h. in Verbindung mit der danach aufgebrachten Außenkapsel ergibt sich eine Dichtwirkung, die auch extrem hohen Anforderungen genügt. Nach dem Zusammenfügen von Gehäusemittelteil und Gehäuseunterteil können dann auch hier die inneren Enden der Anschlußbeine mit den zugeordneten Anschlüssen des am Boden des Gehäuseunterteils verankerten Bauelemente oder der am Boden des Gehäuseunterteils verankerten Baugruppen elektrisch leitend verbunden werden.

Gemäß einer insbesondere für die Verkapselung von Chips entwickelten weiteren Variante des erfindungsgemäßen Verfahrens ist vorgesehen, daß zunächst an die Unterseite eines Insel, Inselsteg und Anschlußbeine umfassenden Systemträgers ein Gehäuseunterteil durch Spritzgießen angeformt wird, daß dann ein Bauelement auf der Insel befestigt wird und die inneren Enden der Anschlußbeine mit den zugeordneten Anschlüssen des Bauelements elektrisch leitend verbunden werden und daß nach dem Zusammenfügen von Gehäuseunterteil und einem Gehäuseoberteil die Außenkapsel angeformt wird. Bei dieser auf eine Massenfertigung abgestimmten Verfahrensweise können dann auch mehrere Systemträger gleichzeitig, z.B. in Form eines 10-fach-Nutzens, verarbeitet werden. Vor der Anformung des Gehäuseunterteils an den Systemträger kann dann gegebenenfalls auch zur weiteren Steigerung der Dichtigkeit auf den Systemträger im Durchtrittsbereich der Anschlußbeine ein Haftvermittler aufgebracht werden. Im Hinblick auf eine möglichst hohe Dichtigkeit hat es sich auch als zweckmäßig erwiesen, wenn beim Anformen des Gehäuseunterteils an den Systemträger die Zwischenräume zwischen den Anschlußbeinen partiell mit thermoplastischem Kunststoff gefüllt werden.

Wird beim Anformen des Gehäuseunterteils an den Systemträger der Inselsteg im thermoplastischen Kunststoff verankert, so ergibt sich hierdurch eine sehr sichere mechanische Halterung der Insel und damit auch des später auf die Insel aufzubringenden Bauelements im Gehäuse.

Die Erfindung gibt auch eine Verkapselung von elektrischen oder elektronischen Bauelementen oder Baugruppen in einem aus mindestens zwei aus thermoplastischem Kunststoff bestehenden Gehäuseteilen zusammengefügten Gehäuse, aus welchem Anschlußbeine nach außen geführt sind, an, bei welcher zumindest im Bereich der Fügestellen des Gehäuses und im Austrittsbereich der Anschlußbeine an das Gehäuse eine Außenkapsel aus einem thermomplastischen Kunststoff durch Spritzgießen angeformt ist. Im Hinblick auf den mechanischen Schutz von Bauelementen oder Baugruppen und auf den Schutz vor innerer Korrosion bietet dann auch diese Verkapselung die bereits im Zusammenhang mit dem erfindungsgemäßen Verfahren erörterten Vorteile. Eine weitere Steigerung der Dichtwirkung kann dann auch dadurch erzielt werden, daß die Außenkapsel und die anderen Gehäuseteile mittels Vor- und Rücksprung ineinander eingreifen. Außerdem ist es besonders wirtschaftlich, wenn die Außenkapsel und die anderen Gehäuseteile aus dem gleichen thermoplastischen Kunststoff durch Spritzgießen hergestellt sind. Im Hinblick auf besonders wirtschaftliche Verarbeitungsbedingungen, auf eine hohe mechanische Stabilität der gesamten Verkapselung und auf eine hohe chemische Stabilität der gesamten Verkapselung hat es sich als besonders günstig erwiesen, wenn die Außenkapsel und die anderen Gehäuseteile aus Polyphenylensulfid bestehen.

Eine weitere Verbesserung der Verkapselung im Hinblick auf eine hermetisch dichte Verbindung wird dadurch erreicht, daß an den Gehäuseteilen in ihrem peripheren Bereich umlaufende Abschnitte mit geringer Wandstärke, insbesondere geschlossene stegförmige Abschnitte ausgebildet sind, die bevorzugt in die Außenkapsel eingebettet und mit dieser verschweißt sind. Eine derartig ausgebildete Verkapselung ist insbesondere für Oberflächenwellen-Filter geeignet.

Zum Verschweißen der an den Gehäuseteilen in ihrem peripheren Bereich umlaufenden Abschnitte mit der Außenkapsel, wird dabei bevorzugt eine Kunststoffmasse für die Abschnitte gewählt, deren Schmelztemperatur gleich oder höher ist als die der Gehäuseteile, wobei die Spritztemperatur beim Anformen der Außenkapsel derart mit der Schmelztemperatur der Gehäusteile abgestimmt wird, daß die Abschnitte durch die Kunststoffmasse teilweise geschmolzen werden und beim Erkalten die gewünschte Schweißbindung mit dieser eingehen.

Durch diese Schweißverbindung wird eine sichere Abdichtung und Isolierung der elektrischen oder elektronischen Bauelemente oder Baugruppen im Inneren der Verkapselung gewährleistet.

Ausführungsbeispiele der Erfindung sind in der Zeichnung dargestellt und werden im folgenden näher beschrieben.

Es zeigen:
- Fig. 1 bis 5: in stark vereinfachter schematischer Darstellung die wesentlichen Verfahrensstadien bei der Verkapselung eines elektronischen Bauelementes in einem aus zwei Gehäuseteilen zusammengefügten Gehäuse,
- Fig. 6 bis 12: in stark vereinfachter schematischer Darstellung die wesentlichen Verfahrensstadien bei der Verkapselung einer Baugruppe in einem aus drei Gehäuseteilen zusammengefügten Gehäuse,
- Fig. 13 bis 20: in stark vereinfachter schematischer Darstellung die wesentlichen Verfahrensstadien bei der Verkapselung eines integrierten Schaltkreises in einem aus zwei Gehäuseteilen zusammengefügten Gehäuse.
- Fig. 21: in vereinfachter, teils geschnittener und schematischer Darstellung eine Draufsicht auf ein Oberflächenwellen-Filter, wobei eines der beiden Gehäuseteile der Verkapselung entfernt ist und
- Fig. 22: einen Schnitt gemäß der Linie II - II nach Fig. 21, wobei das zweite Gehäuseteil auf das erste aufgesetzt ist.

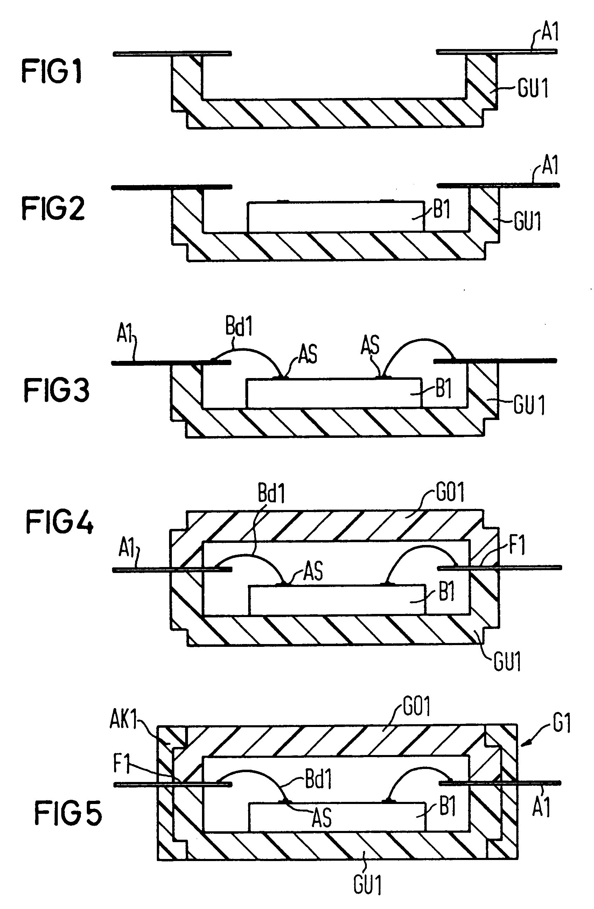

Bei dem anhand der Fig. 1 bis 5 dargestellten ersten Ausführungsbeispiel wird gemäß Fig. 1 ein Gehäuseunterteil GU1 aus einem thermoplastischen Kunststoff durch Spritzgießen hergestellt. Beim Spritzgießen werden dabei die beispielsweise in Form eines Systemträgers zusammenhängenden Anschlußbeine A1 derart in die Hohlform des Spritzgießwerkzeugs eingelegt, daß drei Seiten der Anschlußbeine A1 im Austrittsbereich umspritzt werden und die Oberseite der Anschlußbeine A1 und die Oberseite des Gehäuseunterteils GU1 in einer Ebene liegen.

Nach der Herstellung des Gehäuseunterteils GU1 wird auf dessen Boden gemäß Fig. 2 ein Bauelement B1 beispielsweise durch Kleben verankert, worauf gemäß Fig. 3 die inneren Enden der Anschlußbeine A1 mit den zugeordneten Anschlüssen AS des Bauelementes B1 über feine Bonddrähte Bd1 elektrisch leitend verbunden werden.

Fig. 4 zeigt, daß nach den vorstehend beschriebenen Bonden auf das Gehäuseunterteil GU1 ein Gehäuseoberteil GO1 aufgesetzt wird, wobei die Fügestelle zwischen Gehäuseunterteil GU1 und Gehäuseoberteil GO1 mit F1 bezeichnet ist. Das Gehäuseoberteil GO1 wird ebenfalls aus einem thermoplastischen Kunststoff durch Spritzgießen hergestellt.

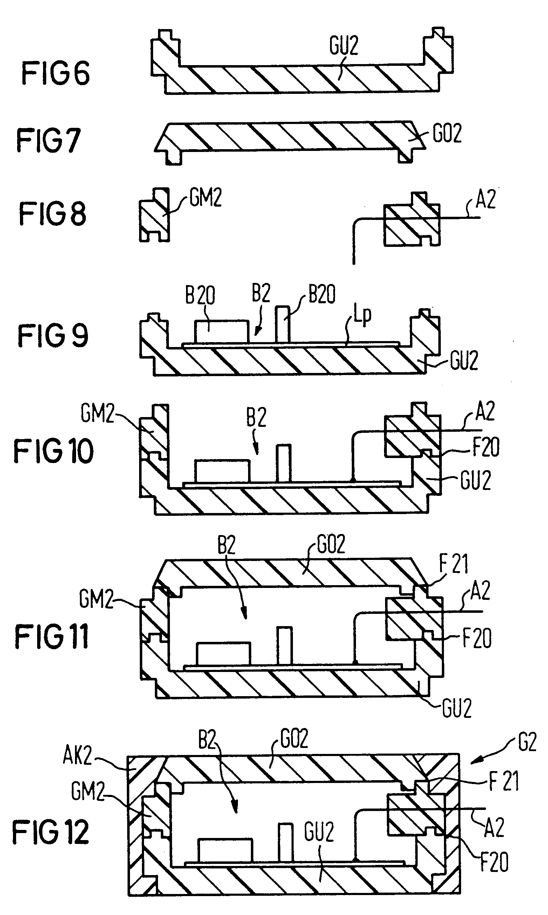

Das gemäß Fig. 4 zusammengesetzte Gebilde wird anschließend in die Hohlform eines weiteren Spritzgießwerkzeugs eingebracht, so daß die in Fig. 5 dargestellte Außenkapsel AK1 zur Vervollständigung des insgesamt mit G1 bezeichneten Gehäuses durch Spritzgießen aus einem thermoplastischen Kunststoff angeformt werden kann. Die Außenkapsel AK1, die über nicht näher bezeichnete Vor- und Rücksprünge mit Gehäuseunterteil GU1 und Gehäuseoberteil GO1 verzahnt ist, bildet eine ringförmig in sich geschlossene Klammer, welche einen festen mechanischen Zusammenhalt der Gehäuseteile gewährleistet und die Fügestelle F1 sowie den Austrittsbereich der Anschlußbeine A1 hervorragend abdichtet. Das Gehäuseunterteil GU1, das Gehäuseoberteil GO1 und die Außenkapsel AK1 werden aus dem gleichen thermoplastischen Kunststoff durch Spritzgießen hergestellt, wobei sich insbesondere Polyphenylensulfid durch seine Verarbeitungseigenschaften, durch seine mechanischen Eigenschaften und durch seine chemischen Eigenschaften auszeichnet.

Bei dem anhand der Fig. 6 bis 12 dargestellten zweiten Ausführungsbeispiele werden gemäß Fig. 6 ein Gehäuseunterteil GU2 und gemäß Fig. 7 ein Gehäuseoberteil GO2 aus einem thermoplastischen Kunststoff durch Spritzgießen hergestellt. Außerdem wird noch gemäß Fig. 8 ein Gehäusemittelteil GM2 ebenfalls aus einen thermoplastischen Kunststoff durch Spritzgießen hergestellt, wobei hier jedoch die beispielsweise in Form eines Systemträgers zusammenhängenden Anschlußbeine A2 derart in die Hohlform des Spritzgießwerkzeugs eingelegt werden, daß sämtliche Anschlußbeine A2 im Austrittsbereich vollständig umspritzt werden.

Auf dem Boden des Gehäuseunterteils GU2 wird dann gemäß Fig. 9 eine insgesamt mit B2 bezeichnete Baugruppe verankert, von welcher im dargestellten Ausführungsbeispiel eine Leiterplatte Lp und Bauelemente B20 zu erkennen sind. Die Verankerung der Leiterplatte Lp erfolgt beispielsweise über in der Zeichnung nicht erkennbare Warzen, die beim Spritzgießen an den Boden des Gehäuseunterteils GU2 angeformt werden und in entsprechende Löcher der Leiterplatte Lp eingreifen.

Nach der Verankerung der Baugruppe B2 auf dem Boden des Gehäuseunterteils GU2 wird gemäß Fig. 10 das Gehäusemittelteil GM2 auf das Gehäuseunterteil GU2 aufgesetzt, worauf die elektrisch leitenden Verbindungen zwischen in den inneren Enden der Anschlußbeine A2 und der Baugruppe in bekannter Weise hergestellt werden. In Fig. 10 ist ferner zu erkennen, daß Gehäuseunterteil GU2 und Gehäusemittelteil GM2 im Bereich der Fügestelle F20 mittels nicht näher bezeichneter Vor- und Rücksprünge ineinander eingreifen. Auch das gemäß Fig. 11 anschließend aufgesetzte, deckelförmige Gehäuseoberteil GO2 ist mit einem ebenfalls nicht näher bezeichneten Bund in der Öffnung des Gehäusemittelteils GM2 gehalten. Die Fügestelle zwischen Gehäusemittelteil GM2 und Gehäuseoberteil GO2 ist mit F21 bezeichnet.

Das gemäß Fig. 11 zusammengesetzte Gebilde wird anschließend in die Hohlform eines weiteren Spritzgießwerkzeugs eingebracht, so daß die in Fig. 12 dargestellte Außenkapsel AK2 zur Vervollständigung des insgesamt mit G2 bezeichneten Gehäuses durch Spritzgießen aus einem thermoplastischen Kunststoff angeformt werden kann. Die Außenkapsel AK2 bildet eine ringförmig in sich geschlossene Kammer, welche einen festen mechanischen Zusammenhalt der Gehäuseteile gewährleistet und die Fügestellen F20 und F21 hervorragend abdichtet. Auch für den Austrittsbereich der Anschlußbeine A2 aus dem Gehäusemittelteil GM2 bildet die Außenkapsel AK2 eine zusätzliche äußere Abdichtung. Das Gehäuseunterteil GU2, das Gehäusemittelteil GM2, das Gehäuseoberteil GO2 und die Außenkapsel AK2 werden aus dem gleichen thermoplastischen Kunststoff durch Spritzgießen hergestellt, wobei auch hier wieder Polyphenylensulfid als Werkstoff besonders gut geeignet ist.

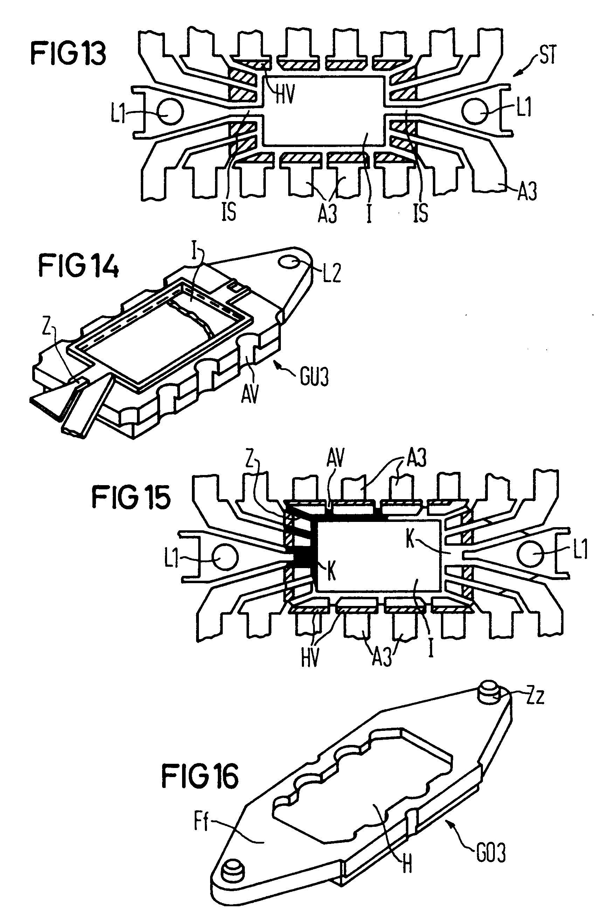

Bei dem anhand der Fig. 13 bis 20 dargestellten dritten Ausführungsbeispiel wird von einem in Fig. 13 dargestellten Systemträger ST ausgegangen, dessen Anschlußbeine mit A3 bezeichnet sind, während die an einem Inselsteg IS hängende rechteckförmige Insel mit I bezeichnet ist. Von den beiden Inselstegen IS ausgehend nach außen sind in die dortigen Bereiche des Systemträgers ST Löcher L1 eingebracht, deren Funktion an späterer Stelle näher erläutert wird. In Fig. 13 ist ferner zu erkennen, daß auf die hier dargestellte Unterseite des Systemträgers ST im Bereich der inneren Enden der Anschlußbeine A3 und im Bereich der Inselstege IS ein Haftvermittler HV beispielsweise mittels Tampondruck aufgebracht wurde.

Gemäß Fig. 14 wird dann an die in Fig. 13 dargestellte Unterseite des Systemträgers ST ein Gehäuseunterteil GU3 durch Spritzgießen aus einem thermoplastischen Kunststoff angeformt. Dabei wird die Insel I vollständig durch den thermoplastischen Kunststoff abgestützt und im Bereich des Inselsteges IS gegen ein Lösen mit einer Klammerung K aus dem thermoplastischen Kunststoff gehalten. Beim Spritzgießen des Gehäuseunterteils GU3 bleiben Anschlußbeinverankerungen AV teilweise ausgespart, während die Zwischenräume Z zwischen den Anschlußbeinen A3 dagegen partiell mit dem thermoplastischen Kunststoff gefüllt werden. Das Gehäuseunterteil GU3 ist ferner mit einem eingespritzten Loch L2 versehen, dessen Lage mit der Lage des zugeordneten Loches L1 im Systemträger ST übereinstimmt.

Fig. 15 zeigt eine Draufsicht auf die Oberseite des Systemträgers ST nach dem Anformen des Gehäuseunterteils GU3 an die Unterseite des Systemträgers ST. Auch hier sind wieder die teilweise ausgesparten Anschlußbeinverankerungen AV, die partiell gefüllten Zwischenräume Z und die Klammerungen K zu erkennen, wobei hier Zwischenräume Z und eine Klammerung K lediglich stellenweise als geschwärzte Bereiche hervorgehoben sind. Fig. 15 zeigt ferner, daß auch die Oberseite des Systemträgers ST im Austrittsbereich der Anschlußbeine A3 zur weiteren Dichtigkeitssteigerung mit einem Haftvermittler HV belegt wird. Danach wird auf die Insel I ein in Fig. 15 nicht dargestelltes Bauelement aufgeklebt und mit seinen Anschlüssen durch Bonden mit den zugeordneten inneren Enden der Anschlußbeine A3 verbunden.

Das in Fig. 16 dargestellte Gehäuseoberteil GO3 wird ebenfalls aus einem thermoplastischen Kunststoff durch Spritzgießen hergestellt. Dabei ist dieses Gehäuseoberteil GO3 im nicht dargestellten Spritzgießwerkzeug so eingeformt, daß die Fügefläche Ff und der Hohlraum H oben liegen und aus der Fügefläche Ff vorstehende Zentrierzapfen Zz nach oben ragen. Auf diese Weise kann dann das an den Systemträger St angeformte Gehäuseoberteil GO3 umgedreht, d.h. mit dem Bauelement nach unten in das geöffnete Spritzgießwerkzeug des Gehäuseoberteils eingelegt werden, wobei die Zentrierzapfen Zz in die zugeordneten Löcher L1 und L2 eindringen.

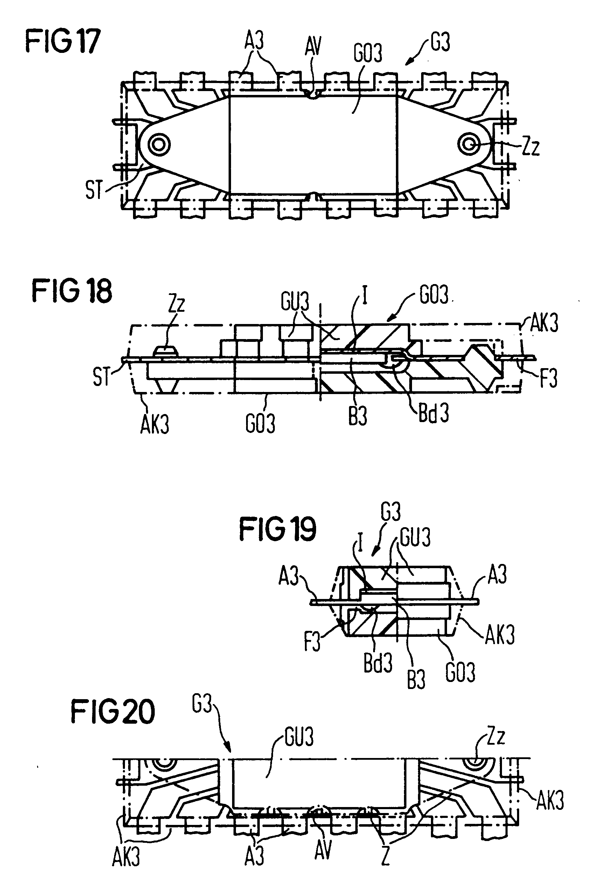

Nach dem vorstehend geschilderten Zusammenfügen von Gehäuseunterteil GU3 und Gehäuseoberteil GO3 wird in einem weiteren Spritzgießwerkzeug zur Vervollständigung des in Fig. 17 mit G3 bezeichneten Gehäuses eine Außenkapsel AK3 aus einem thermoplastischen Kunststoff angeformt. Die Außenkontur dieser Außenkapsel AK3 ist in Fig. 17, bei welcher es sich um eine Draufsicht auf die Oberseite des Gehäuses G3 handelt, durch strichpunktierte Linien angedeutet. Es ist zu erkennen, daß der nach außen freistehende Rest des Systemträgers ST sowie die Anschlußbeinverankerungen AV und die Zwischenräume Z beim Anformen der Außenkapsel AK3 mit thermoplastischen Kunststoff gefüllt werden.

Die Fig. 18 und 19 zeigen zwei halbseitig geschnittene Seitenansichten des Gehäuses G3, wobei auch hier wieder die Kontur der Außenkapsel AK3 durch strichpunktierte Linien aufgezeigt ist. Es ist zu erkennen, daß die Außenkapsel AK3 das Gehäuse G3 in Form einer in sich geschlossenen Klammer umschließt und die Fügestellen F3 zwischen Gehäuseunterteil GU3 und Gehäuseoberteil GO3 sowie den Austrittsbereich der Anschlußbeine A3 sicher abdichtet. Ferner ist deutlich zu erkennen, daß im Gehäuse G3 ein Bauteil B3, bei welchem es sich um einen integrierten Schaltkreis handelt, auf der Insel I so befestigt ist, daß es in den Hohlraum H des Gehäuseoberteils GO3 ragt und auch die feinen Bonddrähte Bd3 zwischen Bauelement B3 und den inneren Enden der Anschlußbeine A3 geschützt im Hohlraum H liegen.

Fig. 20 zeigt schließlich eine lediglich halbseitig dargestellte Draufsicht auf die Unterseite des Gehäuses G3, wobei auch hier wieder die Kontur der Außenkapsel AK3 durch strichpunktierte Linien aufgezeigt wurde. Auch hier ist wieder zu erkennen, daß beim Spritzgießen der Außenkapsel AK3 die Anschlußbeinverankerungen AV und die Zwischenräume Z vollständig mit thermoplastischen Kunststoff ausgefüllt werden.

Das Gehäuseunterteil GU3, das Gehäuseoberteil GO3 und die Außenkapsel AK3 werden durch Spritzgießen aus dem gleichen thermoplastischen Kunststoff hergestellt, wobei sich auch hier Polyphenylensulfid besonders bewährt hat. Polyphenylensulfid (z.B. Warenzeichen Tedur der Fa. Bayer AG, Leverkusen, DE) zeichnet sich durch seine hohe Temperaturbeständigkeit, durch seine hohe Chemikalienbeständigkeit, durch eine niedrige Viskosität in der Schmelze, durch eine geringe Schwindung und durch eine geringe thermische Dehnung aus.

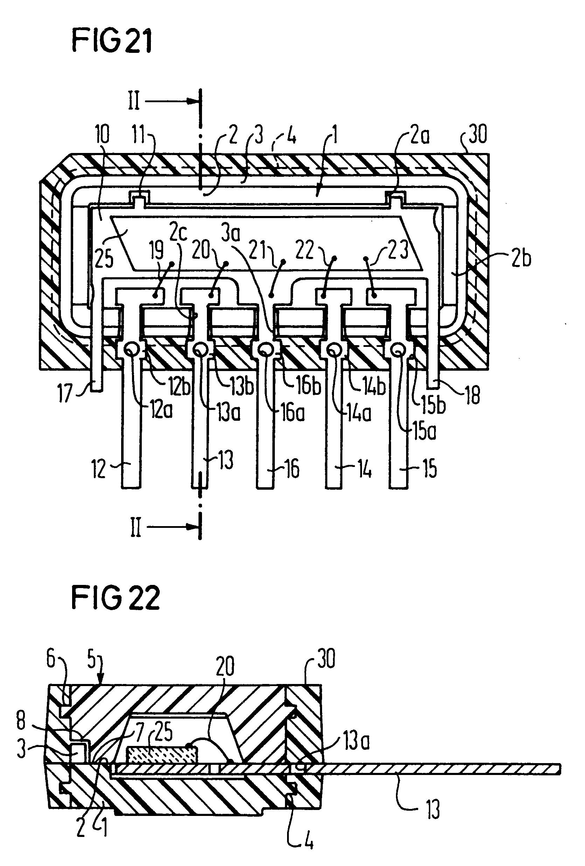

Das in Fig. 21, 22 dargestellte Ausführungsbeispiel nach der Erfindung zeigt ein Oberflächenwellen-Filter, dessen schematisch angedeuteter aktiver Teil 25 auf eine Trägerspinne aufgeklebt ist, die aus einem Metallträger 10 und Anschlußbeinen 12 bis 18 für die Versorgungsanschlüsse besteht, wovon die Anschlußbeine 16 bis 18 zum Anlegen von Bezugspotential geeignet sind. Mit ihren im Inneren der Verkapselung befindlichen Enden sind die Anschlußbeine 12 bis 16 über Bonddrähte 19 bis 23 mit den entsprechenden Elektroden der nicht dargestellten Ein= und Ausgangswandler bzw. mit der gleichfalls nicht dargestellten Schirmung kontaktiert.

Die Verkapselung besitzt zwei schalen= und rechteckförmige Gehäuseteile 1, 5 mit jeweils stufenförmig abgesetzten Seitenwänden 2, 3 bzw. 7, 8, deren eine - siehe Gehäuseteil 1 - im Austrittsbereich 2c, 3a der Anschlußbeine 12 bis 16 und der Anschlüsse 17, 18 durchbrochen sind. Die lagegesicherte Anordnung der Trägerspinne im Gehäuseteil 1 erfolgt z.T. durch die Fixierung der Anschlußbeine in diesen Durchbrechungen und z.T. durch Vorsprünge 11 des Metallträgers 10, die in entsprechende Aussparungen 2a der Seitenwand 2 eingreifen.

Zur, wenngleich nicht ausschließlichen Fixierung der beiden Gehäuseteile 1, 5 trägt die Seitenwand 2 des Gehäuseteils 1 an ihre Schmalseiten einstückig angeformte Vorsprünge 2b, die in entsprechende Ausnehmungen im Gehäuseteil 5 eingreifen.

Die Schmalseiten der Gehäuseteile 1 und 5 tragen peripher umlaufende und geschlossene stegförmige Abschnitte 4, 6 geringer Wandstärke, die an diese Schmalseiten einstückig angeformt und mit einer Außenkapsel 30 aus thermoplastischem Kunststoff verschweißt sind. Die Außenkapsel 30 schafft dabei in Verbindung mit diesen Abschnitten eine weitgehend hermetische Abdichtung des Inneren der Verkapselung und zwar insbesondere auch im kritischen Bereich der Fügestellen des Gehäuses und des Austrittsbereichs der Anschlüsse.

Für die stegförmigen Abschnitte 4, 6 wird dabei bevorzugt eine Kunststoffmasse gewählt, deren Schmelztemperatur gleich oder höher ist als die der Gehäuseteile 1, 5, wobei in der Fertigung die Spritztemperatur derart mit der Schmelztemperatur der Gehäuseteile 1, 5 abgestimmt wird, daß die Abschnitte insbesondere auch aufgrund ihrer geringen Wandstärke durch die Kunststoffmasse teilweise geschmolzen werden und beim Erkalten die gewünschte hermetisch dichte Schweißverbindung mit dieser eingehen.

Zur zusätzlichen Abdichtung im Austrittsbereich 2c, 3a der Anschlußbeine 12 bis 16 und der Anschlüsse 17, 18 ist in diesem Bereich ein Haftvermittler, d.h. Schmelzkleber z.B. Polyamid auf die Anschlußbeine aufgebracht, der mit der Außenkapsel 30 eine innige Verbindung eingeht.

Zur Schaffung einer weiter verbesserten mechanischen Verbindung zwischen der Außenkapsel 30 und den Anschlußbeinen 12 bis 16 können diese in ihrem Durchtrittsbereich durch die Außenkapsel in ihrer Fläche verjüngt oder erweitert und im letztgenannten Fall ggf. zusätzlich durchbrochen sein (siehe 12a - 16a). Durch diese Ausbildung wird eine "Vernietung" der Werkstoffes der Außenkapsel mit den Anschlußbeinen erzielt.

## Patentansprüche

1. Verfahren zum Verkapseln von elektrischen oder elektronischen Bauelementen (B1;B3) oder Baugruppen (B2) in einem aus mindestens zwei aus thermoplastischem Kunststoff bestehenden Gehäuseteilen (GU1,GO1; GU2,GM2, G02; GU3,GO3,1,5) zusammengefügten Gehäuse (G1;G2;G3), aus welchem Anschlußbeine (A1,A2,A3, 12 bis 16) nach außen geführt sind, wobei zumindest im Bereich der Fügestellen (F1,F20,F21; F3) des Gehäuses (G1;G2;G3) und im Austrittsbereich der Anschlußbeine (A1;A2;A3, 12 bis 16) an das Gehäuse (G1;G2;G3) eine Außenkapsel (AK1;AK2;AK3) aus einem thermoplastischen Kunststoff durch Spritzgießen angeformt wird.

2. Verfahren nach Anspruch 1,
**dadurch gekennzeichnet**,
daß die Gehäuse (G1;G3) aus einem Gehäuseunterteil (GU1;GU3) und einem Gehäuseoberteil (GO1;GO3) zusammengefügt werden, daß das Gehäuseunterteil (GU1;GU3) durch Spritzgießen hergestellt wird und daß die Anschlußbeine (A1;A3) beim Spritzgießen des Gehäuseunterteils (GU1;GU3) im Durchtrittsbereich zumindest teilweise umspritzt werden.

3. Verfahren nach Anspruch 2,
**dadurch gekennzeichnet,**
daß nach dem Spritzgießen des Gehäuseunterteils (GU1;GU3) das Bauelement (B1;B3) oder die Baugruppe am Boden des Gehäuseunterteils (GU1;GU3) verankert wird und daß dann die inneren Enden der Anschlußbeine (A1;A3) mit den zugeordneten Anschlüssen (AS) des Bauelements (B1;B3) oder der Baugruppe elektrisch leitend verbunden werden.

4. Verfahren nach Anspruch 1,
**dadurch gekennzeichnet**,
daß die Gehäuse (G2) aus einem Gehäuseunterteil (GU2), einem Gehäusemittelteil (GM2) und einem Gehäuseoberteil (GO2) zusammengefügt werden, daß das Gehäusemittelteil (GM2) durch Spritzgießen hergestellt wird und daß die Anschlußbeine (A2) beim Spritzgießen des Gehäuseunterteils (GM2) im Durchschnittsbereich vollständig umspritzt werden.

5. Verfahren nach Anspruch 4,
**dadurch gekennzeichnet**,
daß nach dem Zusammenfügen von Gehäusemittelteil (GM2) und Gehäuseunterteil (GU2) die inneren Enden der Anschlußbeine (A2) mit den zugeordneten Anschlüssen des am Boden des Gehäuseunterteils (GU2) verankerten Bauelements oder der am Boden des Gehäuseunterteils (GU2) verankerten Baugruppen (BZ) elektrisch leitend verbunden werden.

6. Verfahren nach einem der Ansprüche 1 bis 3,
**dadurch gekennzeichnet**,
daß zunächst an die Unterseite eines Insel (I), Inselsteg (IS) und Anschlußbeine (A3) umfassenden Systemträgers (ST) ein Gehäuseunterteil (GU3) durch Spritzgießen angeformt wird, daß dann ein Bauelement (B3) auf der Insel (I) befestigt wird und die inneren Enden der Anschlußbeine (A3) mit den zugeordneten Anschlüssen des Bauelements (B3) elektrisch leitend verbunden werden und daß nach dem Zusammenfügen von Gehäuseunterteil (GU3) und einem Gehäuseoberteil (G03) die Außenkapsel (AK3) angeformt wird.

7. Verfahren nach Anspruch 6,
**dadurch gekennzeichnet**,
daß auf dem Systemträger (ST) im Durchtrittsbereich der Anschlußbeine (A3) ein Haftvermittler (HV) aufgebracht wird.

8. Verfahren nach Anspruch 6 oder 7,
**dadurch gekennzeichnet**,
daß beim Anformen des Gehäuseunterteils (GU3) an den Systemträger (ST) die Zwischenräume (Z) zwischen den Anschlußbeinen (A3) partiell mit thermoplastischem Kunststoff gefüllt werden.

9. Verfahren nach einem der Ansprüche 6 bis 8,
**dadurch gekennzeichnet**,
daß beim Anformen des Gehäuseunterteils (GU3) an den Systemträger (ST) der Inselsteg (IS) im thermoplastischen Kunststoff verankert wird.

10. Verkapselung von elektrischen oder elektronischen Bauelementen (B1,B3) oder Baugruppen (B2) in einem aus mindestens zwei aus thermoplastischem Kunststoff bestehenden Gehäuseteilen (GU1,GO1;GU2,GM2,GO2;GU3,GO3,1,5) zusammengefügten Gehäuse (G1;G2;G3), aus welchem Anschlußbeine (A1;A2;A3, 12 bis 16) nach außen geführt sind, wobei zumindest im Bereich der Fügestellen (F1;F20,F21;F3) des Gehäuses (G1,G2,G3) und im Austrittsbereich der Anschlußbeine (A1;AS2;A3, 12 bis 16) an das Gehäuse (G1;G2;G3) eine Außenkapsel (AK1;AK2;AK3;30) aus einem thermoplastischen Kunststoff durch Spritzgießen angeformt ist.

11. Verkapselung nach Anspruch 10,
**dadurch gekennzeichnet**,
daß die Außenkapsel (AK1;AK2;AK3) und die anderen Gehäuseteile (CU1,GO1;GU2,GM2,G02;GU3,GO3) mittels Vor- und Rücksprung ineinander eingreifen.

12. Verkapselung nach Anspruch 10 oder 11,
**dadurch gekennzeichnet**,
daß die Außenkapsel (AK1;AK2;AK3) und die anderen Gehäuseteile (GU1,GO1;GU2,GM2,GO2;GU3,GO3) aus dem gleichen thermoplastischen Kunststoff durch Spritzgießen hergestellt sind.

13. Verkapselung nach Anspruch 12,
**dadurch gekennzeichnet**,
daß die Außenkapsel (AK1;AK2;Ak3) und die anderen Gehäuseteile (GU1,GO1;GU2,GM2,GO2;GU3,GO3) aus Polyphenylensulfid bestehen.

14. Verkapselung von elektrischen oder elektronischen Bauelementen oder Baugruppen, insbesondere Oberflächenwellen-Filtern, nach Anspruch 10,
**dadurch gekennzeichnet**,
daß an den Gehäuseteilen (1, 5) in ihrem peripheren Bereich umlaufende Abschnitte (4, 6) mit geringer Wandstärke ausgebildet sind, die mit der Außenkapsel (30) verschweißt sind.

15. Verkapselung nach Anspruch 14,
**dadurch gekennzeichnet**,
daß die Abschnitte (4, 6) in die Außenkapsel (30) eingebettet und mit dieser verschweißt sind.

16. Verkapselung nach Anspruch 14 und 15,
**dadurch gekennzeichnet**,
daß an die Seitenflächen der Gehäuseteile (1, 5) umlaufende sowie geschlossene stegförmige Abschnitte (4, 6) geringer Wandstärke angeformt sind, die in die Außenkapsel (30) eingebettet und mit dieser verschweißt sind.

17. Verkapselung nach Anspruch 14 und einem der vorhergehenden Ansprüche 15 und 16,
**dadurch gekennzeichnet**,
daß im Austrittsbereich (2c, 3a) der elektrischen Anschlußbeine (12 bis 16) und der Anschlüsse (17, 18) ein Haftvermittler auf diese Anschlüsse aufgebracht ist.

18. Verkapselung nach Anspruch 14 und einem der vorhergehenden Ansprüche 15 bis 17,
**dadurch gekennzeichnet**,
daß die Anschlußbeine (12 bis 16) streifenförmig gestaltet und in ihrem Durchtrittsbereich verjüngt sind.

19. Verkapselung nach Anspruch 14 und einem der vorhergehenden Ansprüche 15 bis 18,
**dadurch gekennzeichnet**,
daß die Anschlußbeine (12 bis 16) streifenförmig gestaltet und in ihrem Durchtrittsbereich eine größere Oberfläche (12b bis 16b) aufweisen.

20. Verkapselung nach Anspruch 14 und 19,
**dadurch gekennzeichnet**,
daß die Anschlußbeine (12 bis 16) in ihrem Bereich größerer Oberfläche (12b bis 16b) durchbrochen sind.

21. Verfahren zur Herstellung einer Schweißverbindung zwischen den an den Gehäuseteilen (1, 5) in ihrem peripheren Bereich umlaufenden Abschnitten (4, 6) mit geringer Wandstärke und der Außenkapsel (30) nach Anspruch 14,
**dadurch gekennzeichnet**,
daß für die Abschnitte (4, 6) eine Kunststoffmasse gewählt wird, deren Schmelztemperatur gleich oder höher ist als die der Gehäuseteile (1, 5) und daß die Spritztemperatur beim Anformen der Außenkapsel (30) derart mit der Schmelztemperatur der Gehäuseteile (1, 5) abgestimmt wird, daß die Abschnitte (4, 6) durch die Kunststoffmasse der Außenkapsel (30) teilweise geschmolzen werden und beim Erkalten eine Schweißverbindung mit dieser eingehen.

## Claims

1. Method of encapsulating electrical or electronic components (B1;B3) or assemblies (B2) in a housing (G1;G2;G3) joined together from at least two housing parts (GU1,GO1; GU2,GM2, GO2; GU3,GO3,1,5) consisting of thermoplastic material, from which housing terminal legs (A1,A2,A3, 12 to 16) are led to the outside, there being formed by injection moulding onto the housing (G1;G2;G3), at least in the region of the joints (F1,F2O,F21; F3) of the housing (G1;G2;G3) and in the exit region of the terminal legs (A1;A2;A3, 12 to 16), an outer capsule (AK1;AK2;AK3) of a thermoplastic material.

2. Method according to Claim 1, characterized in that the housings (G1;G3) are joined together from a lower housing part (GU1;GU3) and an upper housing part (GO1;GO3), in that the lower housing part (GU1;GU3) is produced by injection moulding and in that the terminal legs (A1;A3) are at least partially moulded around in the region where they pass through during injection moulding of the lower housing part (GU1;GU3).

3. Method according to Claim 2, characterized in that, after the injection moulding of the lower housing part (GU1;GU3), the component (B1;B3) or the assembly is anchored on the bottom of the lower housing part (GU1;GU3) and in that then the inner ends of the terminal legs (A1;A3) are connected in an electrically conducting manner to the assigned terminals (AS) of the component (B1;B3) or of the assembly.

4. Method according to Claim 1, characterized in that the housings (G2) are joined together from a lower housing part (GU2), a middle housing part (GM2) and an upper housing part (GO2), in that the middle housing part (GM2) is produced by injection moulding and in that the terminal legs (A2) are completely moulded around in the region in which they pass through during injection moulding of the lower housing part (GM2).

5. Method according to Claim 4, characterized in that, after the joining together of middle housing part (GM2) and lower housing part (GU2), the inner ends of the terminal legs (A2) are connected in an electrically conducting manner to the assigned terminals of the component anchored on the bottom of the lower housing part (GU2) or of the assemblies (BZ) anchored on the bottom of the lower housing part (GU2).

6. Method according to one of Claims 1 to 3, characterized in that first of all a lower housing part (GU3) is formed by injection moulding onto the underside of a system carrier (ST) comprising an island (I), island web (IS) and terminal legs (A3), in that then a component (B3) is fastened on the island (I) and the inner ends of the terminal legs (A3) are connected in an electrically conducting manner to the assigned terminals of the component (B3) and in that, after the joining together of lower housing part (G3) and an upper housing part (GO3), the outer capsule (AK3) is formed on.

7. Method according to Claim 6, characterized in that an adhesion promoter (HV) is applied on the system carrier (ST) in the region where the terminal legs (A3) pass through.

8. Method according to Claim 6 or 7, characterized in that, when forming the lower housing part (GU3) onto the system carrier (ST), the interspaces (Z) between the terminal legs (A3) are partially filled with thermoplastic material.

9. Method according to one of Claims 6 to 8, characterized in that, when forming the lower housing part (GU3) onto the system carrier (ST), the island web (IS) is anchored in the thermoplastic material.

10. Encapsulation of electrical or electronic components (B1,B3) or assemblies (B2) in a housing (G1;G2;G3) joined together from at least two housing parts (GU1,GO1; GU2,GM2, GO2; GU3,GO3,1,5) consisting of thermoplastic material, from which housing terminal legs (A1,A2,A3, 12 to 16) are led to the outside, there being formed by injection moulding onto the housing (G1;G2;G3), at least in the region of the joints (F1;F20,F21; F3) of the housing (G1;G2;G3) and in the exit region of the terminal legs (A1;A2;A3, 12 to 16), an outer capsule (AK1;AK2;AK3) of a thermoplastic material.

11. Encapsulation according to Claim 10, characterized in that the outer capsule (AK1;AK2;AK3) and the other housing parts (GU1,GO1;GU2,GM2,GO2;GU3,GO3) engage in one another by means of projections and recesses.

12. Encapsulation according to Claim 10 or 11, characterized in that the outer capsule (AK1;AK2;AK3) and the other housing parts (GU1,GO1;GU2,GM2,GO2;GU3,GO3) are produced from the same thermoplastic material by injection moulding.

13. Encapsulation according to Claim 12, characterized in that the outer capsule (AK1;AK2;AK3) and the other housing parts (GU1,GO1;GU2,GM2,GO2;GU3,GO3) consist of polyphenylene sulphide.

14. Encapsulation of electrical or electronic components or assemblies, in particular surface-wave filters, according to Claim 10, characterized in that on the housing parts (1, 5) there are formed in their peripheral region encircling sections (4, 6) of low wall thickness, which are fused to the outer capsule (30).

15. Encapsulation according to Claim 14, characterized in that the sections (4, 6) are embedded in the outer capsule (30) and fused with the latter.

16. Encapsulation according to Claims 14 and 15, characterized in that onto the side faces of the housing parts (1, 5) there are formed encircling and closed web-shaped sections (4, 6) of low wall thickness, which are embedded in the outer capsule (30) and fused with the latter.

17. Encapsulation according to Claim 14 and one of the preceding Claims 15 and 16, characterized in that in the exit region (2c, 3a) of the electrical terminal legs (12 to 16) and of the terminals (17, 18) there is an adhesion promoter applied to these terminals.

18. Encapsulation according to Claim 14 and one of the preceding Claims 15 to 17, characterized in that the terminal legs (12 to 16) are of a strip-shaped design and are tapered in the region where they pass through.

19. Encapsulation according to Claim 14 and one of the preceding Claims 15 to 18, characterized in that the terminal legs (12 to 16) are of a strip-shaped design and have a larger surface (12b to 16b) in the region where they pass through.

20. Encapsulation according to Claims 14 and 19, characterized in that the terminal legs (12 to 16) are interrupted in their region of larger surface (12b to 16b).

21. Method of producing a fused connection between the encircling sections (4, 6) of low wall thickness on the housing parts (1, 5) in their peripheral region and the outer capsule (30) according to Claim 14, characterized in that a plastic compound of which the melting temperature is equal to or higher than that of the housing parts (1, 5) is chosen for the sections (4, 6) and in that the injection temperature during forming on of the outer capsule (30) is matched in such a way to the melting temperature of the housing parts (1, 5) that the sections (4, 6) are partially melted by the plastic compound of the outer capsule (30) and enter into a fused connection with the latter during cooling.

## Revendications

1. Procédé de blindage de composants (B1; B3) ou de modules (B2) électriques ou électroniques dans un boîtier (G1; G2; G3) qui est composé d'au moins deux parties de boîtier (GU1,GO1; GU2,GM2,G02; GU3,GO3,1,5) en matière thermoplastique, et duquel partent vers l'extérieur des pattes de raccordement (A1,A2, A3,12 à 16), un blindage extérieur (AK1;AK2;AK3) en une matière plastique thermoplastique étant formé par moulage par injection sur le boîtier (G1;G2;G3), au moins dans la partie des zones de jonction (F1,F20,F21;F3) du boîtier (G1;G2;G3) et dans la zone de sortie des pattes de raccordement (A1;A2;A3,12 à 16).

2. Procédé suivant la revendication 1, caractérisé par le fait que les boîtiers (G1;G3) sont composés d'une partie inférieure (GU1;GU3) et d'une partie supérieure (GO1; GO3), que la partie inférieure (GU1 ;GU3) du boîtier est fabriquée par moulage par injection et que les pattes de raccordement (A1;A3) sont au moins partiellement enrobées, dans la zone de traversée, lors du moulage par injection de la partie inférieure (GU1;GU3) du boîtier.

3. Procédé suivant la revendication 2, caractérisé par le fait qu'après le moulage par injection de la partie inférieure (GU1;GU3) du boîtier, le composant (B1;B3) ou le module est ancré dans le fond de la partie inférieure (GU1;GU3) du boîtier et qu'ensuite les extrémités intérieures des pattes de raccordement (A1;A3) sont reliées d'une manière électriquement conductrice aux bornes associées (AS) du ou composant (B1;B3) du module.

4. Procédé suivant la revendication 1, caractérisé par le fait que le boîtier (G2) est composé d'une partie inférieure (GU2), d'une partie médiane (GM2) et d'une partie supérieure (GO2), que la partie médiane (GM2) du boîtier est fabriquée par moulage par injection et que les pattes de raccordement (A2) sont complètement enrobées, dans la zone de traversée, lors du moulage par injection de la partie inférieure (GM2) du boîtier.

5. Procédé suivant la revendication 4, caractérisé par le fait qu'après l'assemblage de la partie médiane (GM2) et de la partie inférieure (GU2) du boîtier, on raccorde d'une manière électriquement conductrice les extrémités intérieures des pattes de raccordement (A2) aux bornes associées du composant, qui est ancré dans le fond de la partie inférieure (GU2) du boîtier, ou des modules (BZ) ancrés dans le fond de la partie inférieure (GU2) du boîtier.

6. Procédé suivant l'une des revendications 1 à 3, caractérisé par le fait qu'on forme tout d'abord, par moulage par injection, une partie inférieure (GU2) du boîtier sur la face inférieure d'un support (ST) du système, qui comprend un îlot (I), une barrette (IS) de raccordement à l'îlot et des pattes de raccordement (AS), qu'on fixe ensuite un composant (83) sur l'îlot (I) et qu'on raccorde de façon électriquement conductrice les extrémités intérieures des pattes de raccordement (3) aux bornes associées du composant (B3), et qu'après l'assemblage de la partie inférieure (GU3) et d'une partie supérieure (GO3) du boîtier, on forme par moulage le capot extérieur (AK3).

7. Procédé suivant la revendication 6, caractérisé par le fait qu'on dépose un adhésif (HV) sur le support (ST) du système, dans la zone de traversée des pattes de raccordement (A3).

8. Procédé suivant l'une des revendications 6 ou 7, caractérisé par le fait que lors de la formation par moulage de la partie inférieure (GU3) du boîtier sur le support (ST) du système, les intervalles (Z) présents entre les pattes de raccordement (A3) sont emplis partiellement par une matière plastique thermoplastique.

9. Procédé suivant l'une des revendications 6 à 8, caractérisé par le fait que lors de la formation par moulage de la partie inférieure (GU3) du boîtier sur le support (ST) du système, la barrette (IS) de raccordement de l'îlot est ancrée dans la matière plastique thermoplastique.

10. Blindage de composants (B1,B3) ou de modules (B2) électriques ou électroniques dans un boîtier (G1; G2; G3) qui est composé d'au moins deux éléments de boîtier (GU1,GO1; GU2,GM2,GO2; GU3,GO3,1,5) en matière plastique thermoplastique, et duquel partent à l'extérieur des pattes de raccordement (A1,A2, A3,12 à 16), un capot extérieur (AK1;AK2;AK3;30) en une matière plastique thermoplastique étant formé par moulage par injection sur le boîtier (G1;G2;G3), au moins au niveau des zones de jonction (F1,F20,F21;F3) du boîtier (G1,G2,G3) et dans la zone de sortie des pattes de raccordement (A1;A2;A3,12 à 16).

11. Blindage suivant la revendication 10, caractérisé par le fait que le blindage extérieur (AK1;AK2; AK3) et les autres parties (GU1,GO1; GU2,GM2,GO2; GU3,GO3) du boîtier s'engagent les uns dans les autres au moyen d'une partie saillante et d'une partie en retrait.

12. Blindage suivant la revendication 10 ou 11, caractérisé par le fait que le blindage extérieur (AK1; AK2; AK3) et les autres parties (GU1,GO1; GU2,GM2,GO2; GU3, GO3) du boîtier sont fabriqués par moulage par injection en la même matière plastique thermoplastique.

13. Blindage suivant la revendication 12, caractérisé par le fait que le blindage extérieur (AK1;AK2; AK3) et les autres parties (GU1,GO1; GU2,GM2,GO2; GU3,GO3) du boîtier sont réalisés en sulfure de phénylène.

14. Blindage de composants de modules électriques ou électroniques, notamment de filtres à ondes de surface, suivant la revendication 10, caractérisé par le fait que dans la zone périphérique des parties (1,5) du boîtier, des sections circonférentielles (4,6), qui sont soudées au blindage extérieur (30), sont réalisées avec une paroi de faible épaisseur.

15. Blindage suivant la revendication 14, caractérisée par le fait que les sections (4,6) sont insérées dans le blindage extérieur (30) et y sont soudées.

16. Blindage suivant les revendications 14 et 15, caractérisé par le fait que des surfaces latérales des parties (1,5) du boîtier sont issues des sections (4,6) en forme de barrettes circonférentielles ainsi que fermées, de faible épaisseur de paroi, qui sont insérées dans le blindage extérieur (30) et qui y sont soudées.

17. Blindage suivant la revendication 14 et l'une des revendications précédentes 15 et 16, caractérisé par le fait que dans la zone de sortie (2c,3a) des pattes de raccordement électrique (12 à 16) et des bornes (17,18), un adhésif est déposé sur ces bornes.

18. Blindage suivant la revendication 14 et l'une des revendications précédentes 15 à 17, caractérisé par le fait que les pattes de raccordement (12 à 16) sont agencées sous la forme de bandes et sont rétrécies au niveau de leurs passages traversant.

19. Blindage suivant la revendication 14 et l'une des revendications précédentes 15 à 18, caractérisé par le fait que les pattes de raccordement (12 à 16) sont réalisées sous la forme de bandes et possèdent une surface plus étendue (12b à 16b), au niveau de leur passage traversant.

20. Blindage suivant l'une des revendications 14 ou 19, caractérisé par le fait que les pattes de raccordement (12 à 16) sont interrompues dans la zone de leur surface plus étendue (12b à 16b).

21. Procédé pour établir un joint soudé entre les sections (4,6) possédant de faible épaisseur de paroi, qui entourent les parties (1,5) du boîtier dans leur zone périphérique, et le blindage extérieur (30) suivant la revendication 14, caractérisé par le fait que pour les sections (4,6), on choisit une composition de matière plastique, dont le point de fusion est égal ou supérieur à celui des parties (1,5) du boîtier, et que, lors du moulage du blindage extérieur (30), on régle la température d'injection sur le point de fusion des parties (1,5) du boîtier de telle sorte que les sections (4,6) soient partiellement fondues par la masse de matière plastique du blindage extérieur (30) et, lors de leur refroidissement, établissent un joint soudé avec ce blindage.
